# FASCICULE DE BREVET EUROPEEN

(11) **EP 0 591 011 B1**
(45) Date de publication et mention de la délivrance du brevet: **05.03.1997**
(21) Numéro de dépôt: 93401963.9
(22) Date de dépôt: 28.07.1993
(51) Int. Cl.: H02H 3/38, H02H 3/50

(54) **Dispositif de détection de défauts sur un réseau de distribution d'énergie électrique souterrain**
Einrichtung zum Feststellen von Fehlern auf einem unterirdischen elektrischen Energieverteilungsnetz
Device for detecting faults on an electric energy distributing underground network

(30) Priorité: 31.07.1992 FR 9209550
(43) Date de publication de la demande: 06.04.1994
(73) Titulaire: ELECTRICITE DE FRANCE Service National, F-75008 Paris (FR)
(72) Inventeur: Bergeal, Jean, F-91120 Palaiseau (FR); Raymongue, Jacques, F-78190 Trappes (FR)
(74) Mandataire: Polus, Camille

(56) Documents cités:
- EP-A- 0 267 500
- EP-A- 0 358 145
- EP-A- 0 411 863

## Description

La présente invention concerne les réseaux de distribution d'énergie électrique souterrains et, en particulier les réseaux dénommés HTA, c'est-à-dire dont la tension est inférieure ou égale à 50kV.

Un nouveau régime de neutre est mis en oeuvre sur ce type de réseaux afin de limiter les courants de défauts à des valeurs beaucoup moins élevées. De ce fait, les détecteurs de défauts actuellement utilisés, basés sur un principe uniquement ampéremétrique, ne peuvent plus détecter des défauts à la terre.

On connaît en particulier des dispositifs détecteur de défauts du type wattmétrique dans lesquels on mesure et on surveille la puissance homopolaire de la ligne à surveiller. Ces dispositifs nécessitent d'être alimentés à travers des capteurs précis et fiables (la précision doit être de l'ordre du degré en ce qui concerne la phase) et à large bande passante (par exemple de 25 à 1000Hz). Il en résulte que ces dispositifs wattmé-triques ne peuvent être utilisés de manière fiable, que s'ils sont alimentés à partir de capteurs très fiables et précis que l'on ne rencontre généralement pas en réseau.

On connaît par ailleurs (EP-A-267 500) des dispositifs de détection des défauts qui comportent un circuit électronique qui reçoit un signal représentatif de la tension homopolaire et un signal représentatif du courant homopolaire de la ligne à surveiller et qui effectue une détection directionnelle des défauts en analysant les variations transitoires du courant homopolaire et de la tension homopolaire (leur signe).

En effet, sur le départ en défaut, le courant transitoire homopolaire est de signe opposé aux courants transitoires homopolaires des départs sains. De plus la variation instantanée de la tension homopolaire se fait dans le même sens que la variation de courant sur les départs sains. La détection s'effectuant sur les composantes transitoires, on effectue un filtrage afin d'éliminer la composante principale à 50Hz du courant homopolaire.

Ces détecteurs de type à détection du courant homopolaire transitoire sont alimentés par des transformateurs et par des tores fournissant le courant homopolaire. Ceci entraîne une dépense importante en particulier en ce qui concerne les transformateurs de tension fournissant la tension homopolaire.

On a essayé d'obtenir un signal significatif de la tension homopolaire en utilisant les diviseurs capacitifs déjà utilisés en réseau pour effectuer la détection de présence de tension et qui alimentent des néons, par exemple. La tension obtenue est assez peu précise et ne permet pas l'utilisation des détecteurs wattmétriques.

En effet, si l'on utilise un diviseur capacitif pour chacune des phases, l'erreur concernant la tension peut varier entre -40 et +50%; de plus il se pose un problème d'adaptation d'impédance.

La présente invention a pour objet un dispositif de détection de défauts sur un réseau de distribution d'énergie électrique souterrain qui puisse être utilisé sur les réseaux comportant le nouveau régime de neutre à limitation du courant homopolaire, qui puisse détecter les défauts monophasés et qui fonctionne de manière fiable sans nécessiter de dispositifs coûteux.

A cet effet la présente invention a pour objet un dispositif de détection de défauts sur un réseau de distribution d'énergie électrique souterrain comportant un circuit électronique qui reçoit un signal représentatif de la tension homopolaire (éventuellement très imprécis) et un signal représentatif du courant homopolaire de la ligne à surveiller, ledit circuit électronique effectuant une détection des variations transitoires du courant homopolaire en comparant le signe du courant homopolaire à celui de la tension homopolaire et le capteur le courant homopolaire étant constitué par un ou plusieurs tores, caractérisé en ce que le capteur de tension est constitué par un condensateur branché entre la borne commune des diviseurs capacitifs branchés sur chaque phase et la terre.

On a constaté qu'aux bornes du condensateur branché entre la borne commune des condensateurs d'un diviseur capacitif comportant un condensateur pour chaque phase et la terre, on obtient une tension de l'ordre de 1 à 2 V qui est suffisamment représentative de la tension homopolaire et qui peut être utilisée dans un circuit de détection fonctionnant sur la base de la surveillance de la variation transitoire du courant homopolaire.

Avantageusement, on prévoit deux circuits à seuil recevant le courant homopolaire et fournissant chacun un signal indicateur de défauts. Le seuil du deuxième circuit est plus élevé que le premier et sert à fournir un signal indicateur d'un défaut monophasé double pour lequel la valeur du courant défaut est plus élevée (cross country fault).

Selon un mode de réalisation de l'invention, le dispositif de détection de défauts comporte un détecteur de la tension du réseau qui annule les signaux de défauts du circuit électronique lorsque la tension du réseau réapparait.

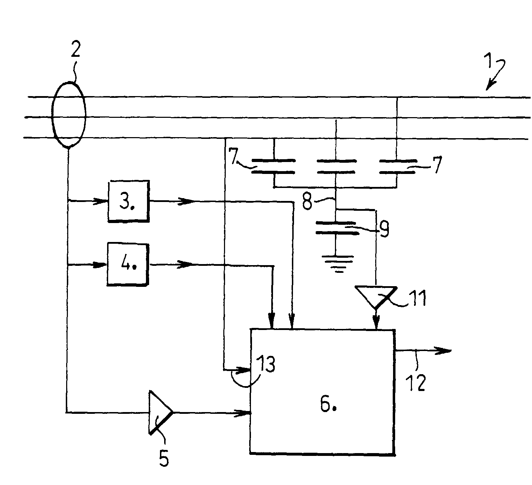

D'autres caractéristiques et avantages de l'invention ressortiront de la description qui suit d'un exemple de réalisation de l'invention, faite en se référant à la figure ci-annexée qui est un schéma synoptique d'un mode de réalisation de l'invention.

On voit sur cette figure un câble électrique 1 autour duquel est disposé un premier tore 2 qui fournit un signal représentatif du courant homopolaire. Le signal fourni par ce tore 2 est envoyé sur un premier circuit à seuil 3, destiné à fournir à sa sortie un signal indiquant un défaut monophasé à la terre.

Le signal de sortie du tore 2 est également envoyé sur un deuxième circuit à seuil 4 qui est réglé à un seuil plus élevé et qui fournit un signal significatif d'un défaut monophasé double (cross country fault).

Le signal de sortie du tore 2 est également envoyé à un amplificateur 5 dont le signal de sortie est appliqué à un circuit 6 de détection de défauts par surveillance des variations transitoires du courant homopolaire.

Sur les conducteurs du câble 1 sont représentés respectivement trois condensateurs 7 qui constituent le diviseur capacitif et comportent une borne commune 8. Entre la terre et cette borne commune 8 est branché un condensateur 9. Il a été constaté que l'on peut recueillir aux bornes de ce condensateur 9 une tension dont la valeur est de l'ordre de 1 à 2 V et qui est suffisamment représentative de la tension homopolaire pour permettre au circuit 6 de surveillance du courant homopolaire transitoire de fonctionner de manière fiable. Cette tension est transmise par l'intermédiaire d'un amplificateur opérationnel 11.

Le fonctionnement du circuit 6 est commandé par les signaux de sortie des deux circuits à seuil 3 et 4, c'est-à-dire que lors de l'apparition d'un défaut, ce circuit effectue une comparaison des signes des transitoires du courant homopolaire et de la tension homopolaire de la ligne. Le circuit électronique 6 reçoit également en 13 une information significative de la réapparition de la tension du réseau. Cette tension peut être par exemple prise sur une phase de la ligne et lorsqu'elle atteint un certain seuil, elle agit sur le détecteur 6 pour supprimer le signal indicateur de défauts.

La validité de la détection est confirmée par l'existence, par exemple 100ms après le dépassement de seuil par le courant transitoire, d'une tension homopolaire supérieure à un seuil qui peut être réglable, par exemple entre 5 et 50% de la valeur de la tension simple du réseau.

Un tel circuit de détection de type transitoire peut fonctionner avec des capteurs peu précis, en particulier de capteurs tels que décrits plus haut.

Le dispositif de détection de défauts selon l'invention peut être constitué de manière autonome et comporter une alimentation autonome constituée par exemple par des piles au lithium, ce qui lui confère une autonomie de plusieurs années.

## Revendications

1. Dispositif de détection de défauts sur un réseau de distribution d'énergie électrique souterrain (1) comportant un circuit électronique (6) qui reçoit un signal représentatif de la tension homopolaire et un signal représentatif du courant homopolaire de la ligne à surveiller, ledit circuit électronique effectuant une détection des variations transitoires du courant homopolaire en comparant le signe du courant homopolaire à celui de la tension homopolaire et le capteur de courant homopolaire étant constitué par un ou plusieurs tores (2), caractérisé en ce que le capteur de tension est constitué par un condensateur branché (9) entre la borne commune (8) des condensateurs (7) d'un diviseur capacitif branchés sur chaque phase et la terre.

2. Dispositif de détection de défauts selon la revendication 1, caractérisé en ce qu'il comporte un premier circuit à seuil (3) recevant le courant homopolaire et fournissant un signal indicateur de défauts.

3. Dispositif de détection de défauts selon la revendication 2, caractérisé en ce qu'il comporte un deuxième circuit à seuil (4) dont le seuil est plus élevé que le premier pour la détection des défauts polyphasés.

4. Dispositif de détection de défauts selon la revendication 1, caractérisé en ce qu'il comporte un détecteur de la tension du réseau (13) qui annule le signal du circuit électronique lorsque la tension du réseau réapparaît.

## Patentansprüche

1. Vorrichtung zum Erfassen von Fehlern in einem unterirdischen Netz (1) zum Verteilen elektrischer Energie, mit einer elektronischen Schaltung (6), die ein Signal, das für die gleichpolige Spannung repräsentativ ist, und ein Signal, das für den gleichpoligen Strom der zu überwachenden Leitung repräsentativ ist, empfängt, wobei die elektronische Schaltung eine Erfassung von Durchgangsänderungen des gleichpoligen Stromes durchführt, indem das Vorzeichen des gleichpoligen Stromes mit dem der gleichpoligen Spannung verglichen wird, und wobei der Aufnehmer für den gleichpoligen Strom durch eine oder mehrere Toresspuren (2) gebildet ist, dadurch gekennzeichnet, daß der Spannungsaufnehmer durch einen Kondensator (9) gebildet ist, der zwischen dem gemeinsamen Anschluß (8) der Kondensatoren (7) eines kapazitiven Teilers, die auf jede Phase verzweigt sind, und der Erde verzweigt ist.

2. Vorrichtung zur Fehlererfassung nach Anspruch 1, dadurch gekennzeichnet, daß sie eine erste Schwellenschaltung (3) aufweist, die die gleichpoligen Ströme empfängt und ein Signal liefert, das Fehler anzeigt.

3. Vorrichtung zur Fehlererfassung nach Anspruch 2, dadurch gekennzeichnet, daß sie eine zweite Schwellenschaltung (4) aufweist, deren Schwelle höher liegt als die erste, für die Erfassung von polyphasischen Fehlern.

4. Vorrichtung zur Fehlererfassung nach Anspruch 1, dadurch gekennzeichnet, daß sie einen Detektor für die Spannung des Netzes (13) aufweist, der das Signal der elektronischen Schaltung ausschaltet, bis die Spannung des Netzes wieder auftritt.

## Claims

1. Device for detecting faults on an underground electrical-energy distribution grid (1) including an electronic circuit (6) which receives a signal representative of the zero-phase-sequence voltage and a signal representative of the zero-phase-sequence current of the line to be monitored, the said electronic circuit performing a detection of the transient variations in the zero-phase-sequence current by comparing the sign of the zero-phase-sequence current with that of the zero-phase-sequence voltage, and the zero-phase-sequence current sensor consisting of one or more tori (2), characterized in that the voltage sensor consists of a capacitor (9) connected between the common terminal (8) of the capacitors (7) of a capacitive divider which are connected to each phase and earth.

2. Fault detection device according to Claim 1, characterized in that it includes a first threshold circuit (3) receiving the zero-phase-sequence current and supplying a fault-indicator signal.

3. Fault detection device according to Claim 2, characterized in that it includes a second threshold circuit (4) the threshold of which is higher than the first one for detecting multi-phase faults.

4. Fault detection device according to Claim 1, characterized in that it includes a detector of the grid voltage (13) which cancels the signal from the electronic circuit when the grid voltage reappears.
